# EUROPEAN PATENT SPECIFICATION

(11) **EP 3 459 114 B1**
(45) Date of publication and mention of the grant of the patent: **26.01.2022**
(21) Application number: 17799908.3
(22) Date of filing: 11.05.2017
(51) Int. Cl.: G11C 16/14, G11C 16/04, G11C 7/18, G11C 8/14, H01L 27/04, H01L 27/115, H01L 27/1159, G11C 16/10

(54) **ARRAY OF THREE-GATE FLASH MEMORY CELLS WITH INDIVIDUAL MEMORY CELL READ, PROGRAM AND ERASE**
ANORDNUNG VON DREI-GATE-FLASH-SPEICHERZELLEN MIT INDIVIDUELLER SPEICHERZELLENAUSLESUNG, -PROGRAMMIERUNG UND -LÖSCHUNG
RÉSEAU DE CELLULES DE MÉMOIRE FLASH À TROIS PORTES AYANT UNE LECTURE, UN PROGRAMME ET UN EFFACEMENT DE CELLULES DE MÉMOIRE INDIVIDUELLES

(30) Priority: 17.05.2016 US 201662337582 P
(43) Date of publication of application: 27.03.2019
(73) Proprietor: SILICON STORAGE TECHNOLOGY, INC., San Jose, CA 95134 (US)
(72) Inventor: TRAN, Hieu Van, San Jose, CA 95135 (US); TIWARI, Vipin, Dublin, CA 94568 (US); DO, Nhan, Saratoga, CA 95070 (US)
(74) Representative: Betten & Resch
(86) International application number: PCT/US2017/032280
(87) International publication number: WO 2017/200850

(56) References cited:
- US-A- 5 138 576
- US-A- 5 469 397
- US-A- 5 643 814
- US-A1- 2003 034 510
- US-A1- 2004 125 655
- US-A1- 2006 170 028
- US-A1- 2014 269 062
- US-A1- 2014 269 062
- US-A1- 2015 213 898
- US-A1- 2016 133 639
- US-B1- 6 274 436

## Description

### RELATED APPLICATIONS

This application claims the benefit of U.S. Provisional Application No. 62/337,582 filed on May 17, 2016.

### FIELD OF THE INVENTION

The present invention relates to non-volatile memory arrays.

### BACKGROUND OF THE INVENTION

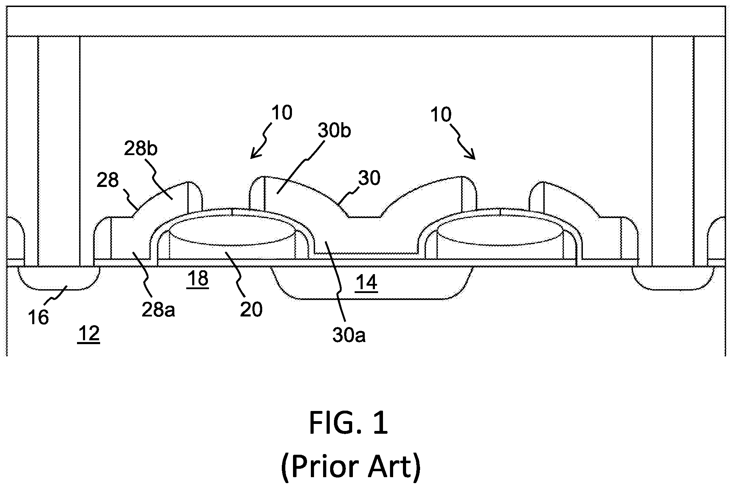

Split gate non-volatile memory cells having three conductive gates, and arrays of such cells, are known. For example, U.S. Patent 7,315,056 ("the '056 patent") discloses an array of split gate non-volatile memory cells, and is incorporated herein by reference for all purposes. The memory cell is shown in Fig. 1. Each memory cell 10 includes source and drain regions 14/16 formed in a semiconductor substrate 12, with a channel region 18 there between. A floating gate 20 is formed over and insulated from (and controls the conductivity of) a first portion of the channel region 18, and over a portion of the source region 14. A select (word line) gate 28 has a first portion 28a that is disposed over and insulated from (and controls the conductivity of) a second portion of the channel region 18, and a second portion 28b that extends up and over the floating gate 20. A program/erase gate 30 has a first portion disposed over the source region 14 and is laterally adjacent to the floating gate 20, and a second portion 30b that extends up and over the floating gate 20.

The memory cell is erased (where electrons are removed from the floating gate) by placing a high positive voltage on the PE gate 30, which causes electrons on the floating gate 20 to tunnel through the intermediate insulation from the floating gate 20 to the PE gate 30 via Fowler-Nordheim tunneling.

The memory cell is programmed (where electrons are placed on the floating gate) by placing a positive voltage on the select gate 28, and a positive voltage on the source 14 and a positive voltage on the PE gate 30. Electron current will flow from the drain 16 towards the source 14. The electrons will accelerate and become heated when they reach the gap between the select gate 28 and the floating gate 20. Some of the heated electrons will be injected through the gate oxide onto the floating gate 20 due to the attractive electrostatic force from the floating gate 20.

The memory cell is read by placing positive read voltages on the drain 16 and select gate 28 (which turns on the channel region under the select gate). If the floating gate 20 is positively charged (i.e. erased of electrons and positively coupled to the source 14), then the portion of the channel region under the floating gate 20 is turned on as well, and current will flow across the channel region 18, which is sensed as the erased or "1" state. If the floating gate 20 is negatively charged (i.e. programmed with electrons), then the portion of the channel region under the floating gate 20 is mostly or entirely turned off, and current will not flow (or there will be little flow) across the channel region 18, which is sensed as the programmed or "0" state.

Exemplary operating voltages can be:

**TABLE 1**

| Operation | Select Gate (28) | Drain (16) | PE Gate (30) | Source (14) |
|---|---|---|---|---|
| Erase | 0 | 0 | 10-12 Volts | 0 |
| Program | 1-2 Volts | ∼1 µA | 4-6 Volts | 6-8 Volts |
| Read | 1.5-3.3 Volts | 0.5-1.0 Volts | 0 | 0 |

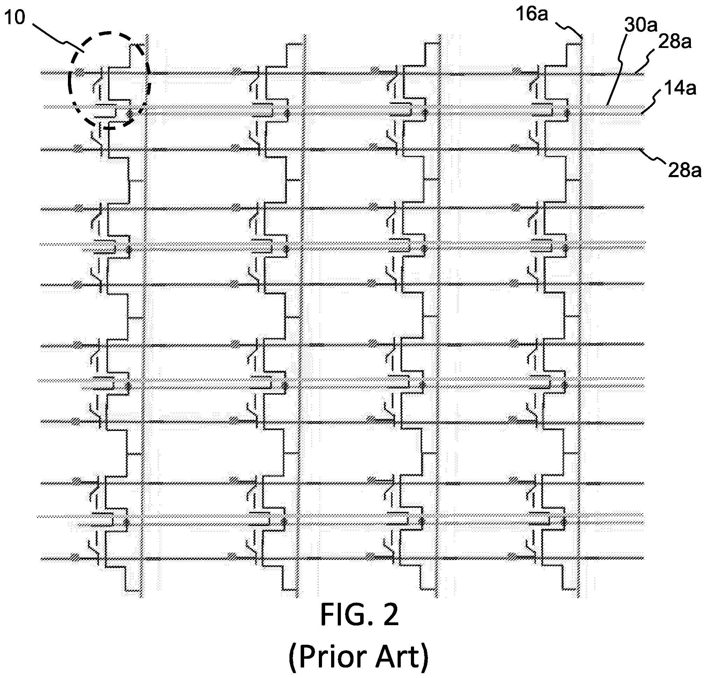

The architecture of the memory array is shown in Fig. 2. The memory cells 10 are arranged in rows and columns. In each column, the memory cells are arranged end to end in mirror fashion, so that they are formed as pairs of memory cells each sharing a common source region 14, and each adjacent set of memory cell pairs sharing a common drain region 16. All the source regions 14 for any given row of memory cells are electrically connected together by a source line 14a. All the drain regions 16 for any given column of memory cells are electrically connected together by a bit line 16a. All the select gates 28 for any given row of memory cells are electrically connected together by a select gate line 28a. All the PE gates 30 for any given row of memory cells are electrically connected together by a PE gate line 30a. Therefore, while the memory cells can be individually programmed and read, memory cell erasure is performed by pairs of rows (each pair of rows of memory cells sharing PE gates 30 are erased together, by the application of a high voltage on the PE gate line 30a). If a particular memory cell is to be erased, all the memory cells in the two rows are also erased.

Recently, new applications for split gate non-volatile memory cells have been developed that require true single bit operation (i.e. each memory cell can be individually programmed, read, and erased, without any interference from or disturbing the programming state of adjacent memory cells). Therefore, there is a need for an array of split gate non-volatile memory cells having three conductive gates which can be independently programmed, read and erased.

US 2014/269062 A1 discloses a method of reading a memory device having rows and columns of memory cells formed on a substrate, where each memory cell includes spaced apart first and second regions with a channel region therebetween, a floating gate disposed over a first portion of the channel region, a select gate disposed over a second portion of the channel region, a control gate disposed over the floating gate, and an erase gate disposed over the first region. The method includes placing a small positive voltage on the unselected source lines, and/or a small negative voltage on the unselected word lines, during the read operation to suppress sub-threshold leakage and thereby improve read performance.

US 6 274 436 B1 discloses that a method is disclosed for creating a sub-minimum opening in a semiconductor device, comprising the steps of: a) providing a first layer; b) providing a second layer over said first layer; c) providing a third layer over said second layer; d) providing a photoresist mask over said third layer; e) etching said third layer to form defined structures; f) depositing a fourth layer for forming spacers; g) etching said fourth layer to form said spacers; and h) etching said first layer to form an opening in said first layer. In etching the fourth layer to form the spacers, the third layer is generally etched away to form an opening to the first layer, and, in the following step, an opening (or feature) can be etched on the first layer. Generally speaking, the first and third layers can be of any material and should have similar etching rate; the second and fourth layers can be of any material and should have similar etching rate. However, the material for the first and third layers versus the material for the second and fourth layers should have highly dissimilar etching rates. Materials for these layers include and are not limited to polysilicon, oxide, nitride, and metal. US 2006/170028 A1 discloses that a non-volatile memory device includes a floating gate formed on a substrate with a gate insulation layer interposed therebetween, a tunnel insulation layer formed on the floating gate, a select gate electrode inducing charge introduction through the gate insulation layer, and a control gate electrode inducing charge tunneling occurring through the tunnel insulation layer. The select gate electrode is insulated from the control gate electrode. According to the non-volatile memory device, a select gate electrode and a control gate electrode are formed on a floating gate, and thus a voltage is applied to the respective gate electrodes to write and erase data.

### BRIEF SUMMARY OF THE INVENTION

The present invention relates to memory devices according to claims 1 and 2, and methods according to claims 5 and 8.

A memory device includes a substrate of semiconductor material and a plurality of memory cells formed on the substrate and arranged in an array of rows and columns. Each of the memory cells includes spaced apart source and drain regions in the substrate, with a channel region in the substrate extending there between, a floating gate disposed over and insulated from a first portion of the channel region which is adjacent the source region, a select gate disposed over and insulated from a second portion of the channel region which is adjacent the drain region, and a program-erase gate disposed over and insulated from the source region. Each of the columns of memory cells includes a source line that electrically connects together all the source regions for the column of memory cells. Each of the columns of memory cells includes a bit line that electrically connects together all the drain regions for the column of memory cells. Each of the rows of memory cells includes a select gate line that electrically connects together all the select gates of the memory cells for the row of memory cells. Each of the rows of memory cells includes a program-erase gate line that electrically connects together all the program-erase gates of the memory cells for the row of memory cells.

A memory device includes a substrate of semiconductor material and a plurality of memory cells formed on the substrate and arranged in an array of rows and columns, wherein the rows of the memory cells are arranged in alternating even and odd numbered rows. Each of the memory cells includes spaced apart source and drain regions in the substrate, with a channel region in the substrate extending there between, a floating gate disposed over and insulated from a first portion of the channel region which is adjacent the source region, a select gate disposed over and insulated from a second portion of the channel region which is adjacent the drain region, and a program-erase gate disposed over and insulated from the source region. Each of the rows of memory cells includes a source line that electrically connects together all the source regions for the row of memory cells. Each of the columns of memory cells includes a bit line that electrically connects together all the drain regions for the column of memory cells. Each of the columns of memory cells includes a first select gate line that electrically connects together all the select gates of the memory cells for the column of memory cells that are in the odd numbered rows or the even numbered rows of the memory cells. Each of the columns of memory cells includes a program-erase gate line that electrically connects together all the program-erase gates of the memory cells for the column of memory cells.

A method according to an example not forming part of the claimed methods of erasing a selected memory cell in a memory device having a substrate of semiconductor material and a plurality of memory cells formed on the substrate and arranged in an array of rows and columns, wherein one of the plurality of memory cells is a selected memory cell. Each of the memory cells includes spaced apart source and drain regions in the substrate, with a channel region in the substrate extending there between, a floating gate disposed over and insulated from a first portion of the channel region which is adjacent the source region, a select gate disposed over and insulated from a second portion of the channel region which is adjacent the drain region, and a program-erase gate disposed over and insulated from the source region. Each of the rows of memory cells includes a source line that electrically connects together all the source regions for the row of memory cells. Each of the columns of memory cells includes a bit line that electrically connects together all the drain regions for the column of memory cells. Each of the rows of memory cells includes a select gate line that electrically connects together all the select gates of the memory cells for the row of memory cells. Each of the columns of memory cells includes a program-erase gate line that electrically connects together all the program-erase gates of the memory cells for the column of memory cells. The method includes applying a positive voltage to one of the program-erase gate lines that is electrically connected to the program-erase gate of the selected memory cell, and a ground voltage to all the others of the program-erase gate lines, and applying a ground voltage to one of the source lines that is electrically connected to the source region of the selected memory cell, and a positive voltage to all the others of the source lines.

A method of erasing a selected memory cell of a memory device having a substrate of semiconductor material, and a plurality of memory cells formed on the substrate and arranged in an array of rows and columns, wherein one of the plurality of memory cells is a selected memory cell. Each of the memory cells includes spaced apart source and drain regions in the substrate, with a channel region in the substrate extending there between, a floating gate disposed over and insulated from a first portion of the channel region which is adjacent the source region, a select gate disposed over and insulated from a second portion of the channel region which is adjacent the drain region, and a program-erase gate disposed over and insulated from the source region. Each of the columns of memory cells includes a source line that electrically connects together all the source regions for the column of memory cells. Each of the columns of memory cells includes a bit line that electrically connects together all the drain regions for the column of memory cells. Each of the rows of memory cells includes a select gate line that electrically connects together all the select gates of the memory cells for the row of memory cells. Each of the rows of memory cells includes a program-erase gate line that electrically connects together all the program-erase gates of the memory cells for the row of memory cells. The method includes applying a positive voltage to one of the program-erase gate lines that is electrically connected to the program-erase gate of the selected memory cell, and a ground voltage to all the others of the program-erase gate lines, and applying a ground voltage to one of the source lines that is electrically connected to the source region of the selected memory cell, and a positive voltage to all the others of the source lines.

A method of erasing a selected memory cell of a memory device having a substrate of semiconductor material and a plurality of memory cells formed on the substrate and arranged in an array of even and odd numbered rows and even and odd numbered columns, wherein one of the plurality of memory cells is a selected memory cell. Each of the memory cells includes spaced apart source and drain regions in the substrate, with a channel region in the substrate extending there between, a floating gate disposed over and insulated from a first portion of the channel region which is adjacent the source region, a select gate disposed over and insulated from a second portion of the channel region which is adjacent the drain region, and a program-erase gate disposed over and insulated from the source region. Each of the rows of memory cells includes a source line that electrically connects together all the source regions for the row of memory cells. Each of the columns of memory cells includes a bit line that electrically connects together all the drain regions for the column of memory cells. Each of the columns of memory cells includes a first select gate line that electrically connects together all the select gates of the memory cells for the column of memory cells that are in the odd numbered rows or the even numbered rows of the memory cells. Each of the columns of memory cells includes a program-erase gate line that electrically connects together all the program-erase gates of the memory cells for the column of memory cells. The method includes applying a positive voltage to one of the program-erase gate lines that is electrically connected to the program-erase gate of the selected memory cell, and a ground voltage to all the others of the program-erase gate lines, and applying a ground voltage to one of the source lines that is electrically connected to the source region of the selected memory cell, and a positive voltage to all the others of the source lines.

Other objects and features of the present invention will become apparent by a review of the specification, claims and appended figures.

### BRIEF DESCRIPTION OF THE DRAWINGS

Fig. 1 is a side cross sectional view of conventional 3-gate non-volatile memory cell.
Fig. 2 is a diagram illustrating a conventional array architecture for the 3-gate memory cell of Fig. 1.
Fig. 3 is a schematic drawing of the 3-gate non-volatile memory cell architecture not forming part of the present invention.
Fig. 4 is a schematic drawing of an alternate embodiment of the 3-gate non-volatile memory cell architecture of the present invention.
Fig. 5 is a schematic drawing of another alternate embodiment of the 3-gate non-volatile memory cell architecture of the present invention.
Fig. 6 is a schematic drawing of yet another alternate embodiment of the 3-gate non-volatile memory cell architecture of the present invention.

### DETAILED DESCRIPTION OF THE INVENTION

The present invention involves new architecture configurations for arrays of 3-gate, split-gate, non-volatile memory cells that provide unique (random order) programming, reading and erasing of single memory cells (i.e., true single bit operation).

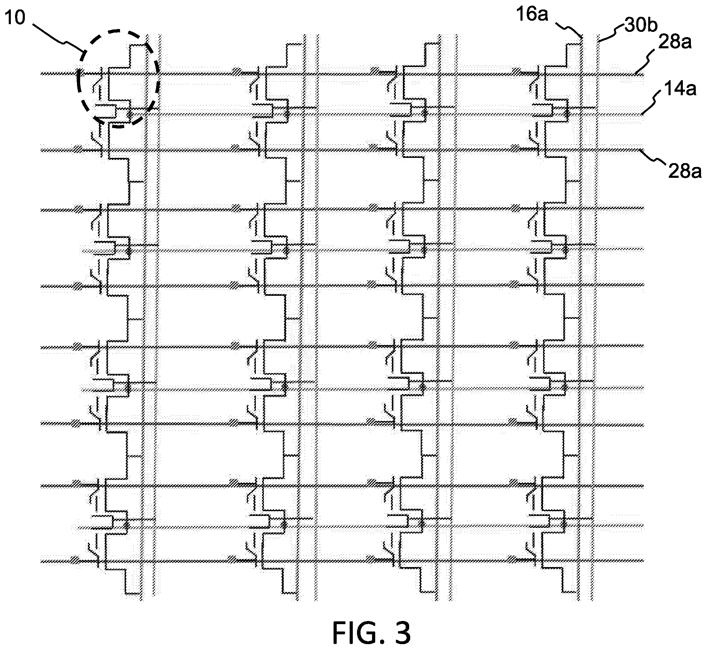

For the three-gate cell of Fig. 1, the memory array architecture not forming part of the present invention that provides true single bit operation is shown in Fig. 3. The main difference between the 3-gate single bit operation architecture of Fig. 3, and the conventional 3-gate architecture discussed above with respect to Fig. 2, is that the horizontal PE gate lines 30a (one for each pair of memory cell pairs) have been replaced with vertical PE gate lines 30b. Specifically, each column of memory cells includes a PE gate line 30b that electrically connects together all the PE gates 30 for the column of memory cells. By reorienting the PE gate lines in this manner, any memory cell in the array can be individually programmed, erased and read. Exemplary operational voltages to erase, program or read any given target memory cell are shown in Table 2 below:

**TABLE 2**

| | PE (30) | | WL (28) | | BL (16) | | SL (14a) | |
|---|---|---|---|---|---|---|---|---|
| | sel | unsel | sel | unsel | sel | unsel | sel | unsel |
| Erase | VPEGerase | gnd | gnd | gnd | gnd | gnd/ VBLerinh | gnd | VSLerinh |
| Program | VPEGprg /gnd | gnd | VWLprg | gnd | Iprog | VBLprginh | VSprg | gnd |
| Read | gnd | gnd | VWLrd | gnd | VBLrd | gnd | VSrd | float/ gnd |

| | | | | | | | | |
|---|---|---|---|---|---|---|---|---|
| (sel = line that intersects target memory cell) (unsel = line that does not intersect target memory cell). | | | | | | | | |

Numerical (non-limiting) examples are shown in Table 3 below:

**TABLE 3**

| | |
|---|---|
| VPEGerase | 8-11.5v |
| VSLerinh | 3-6v |
| VB Lerinh | 1-2.5v |
| VPEGprg | 4-6v |
| VWLprg | 0.8-1.2v |
| VB Lprginh | 1-2.5v |
| Iprog | 1-3ua |
| VSprg | 4-8V |
| VWLrd | 0.4-2.5V |
| VBLrd | 1-2V |
| VSrd | 0-0.6V |

During erase, only the selected cell will have a high voltage on its PE gate 30 in combination with its source region 14 being at ground, so that electrons will tunnel off the floating gate 20. Any unselected cells in the same column that have a high voltage applied to their PE gates 30 will also have an inhibit voltage applied to their source regions 14 that is sufficiently high to inhibit any tunneling of electrons off of the floating gate (i.e. the electrons will see positive voltages in two opposing directions).

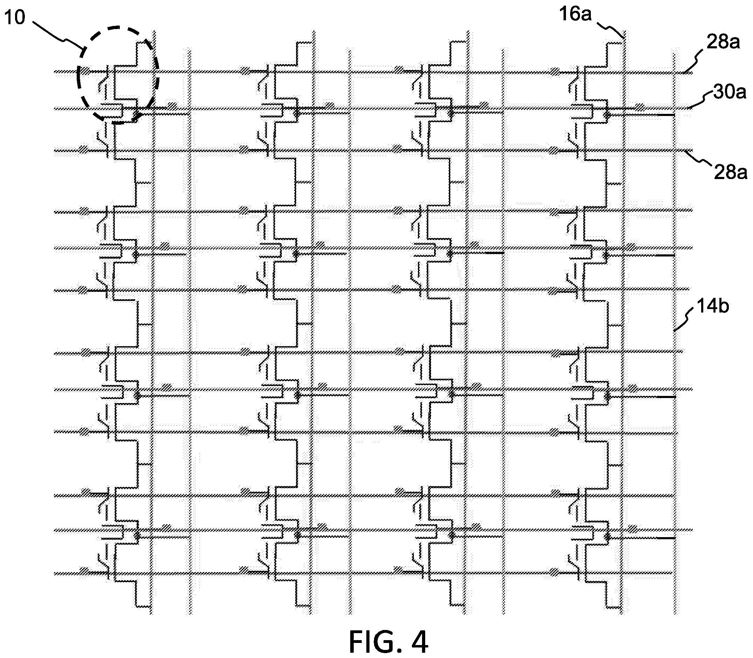

Fig. 4 illustrates an alternate embodiment of the 3-gate single bit operation architecture. The main difference between the 3-gate single bit operation architecture of Fig. 4, and the conventional 3-gate architecture discussed above with respect to Fig. 2, is that horizontal source lines 14a (one for each row) have been replaced with vertical source lines 14b (one for each column). Specifically, each column of memory cells includes a source line 14b electrically connecting together all the source regions 14 for all the memory cells 10 in that column. By reorienting the source lines in this manner, any memory cell in the array can be individually programmed, erased and read without adversely affecting the memory state of adjacent memory cells. The Table 2 operational values similarly apply to this embodiment.

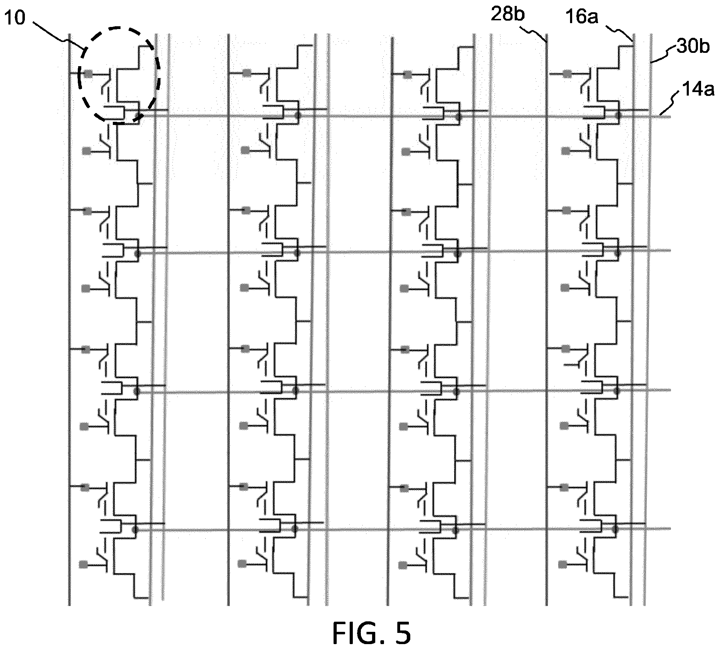

Fig. 5 illustrates another alternate embodiment of the 3-gate single bit operation architecture. The main difference between the 3-gate single bit operation architecture of Fig. 5, and the conventional 3-gate architecture discussed above with respect to Fig. 2, is that horizontal word lines 28a (one for each row) have been replaced with vertical word lines 28b (one for each column). Specifically, each column of memory cells includes a word line 28b electrically connecting together all the select gates 28 in the odd rows of memory cells for the column of memory cells (the even row select gates are not used). By reorienting the word lines in this manner, any memory cell in the array can be individually programmed, erased and read without adversely affecting the memory state of adjacent memory cells. The Table 2 operational values similarly apply to this embodiment. It should be noted that word line 28b can electrically connect to all the even row select gates instead of the odd row select gates.

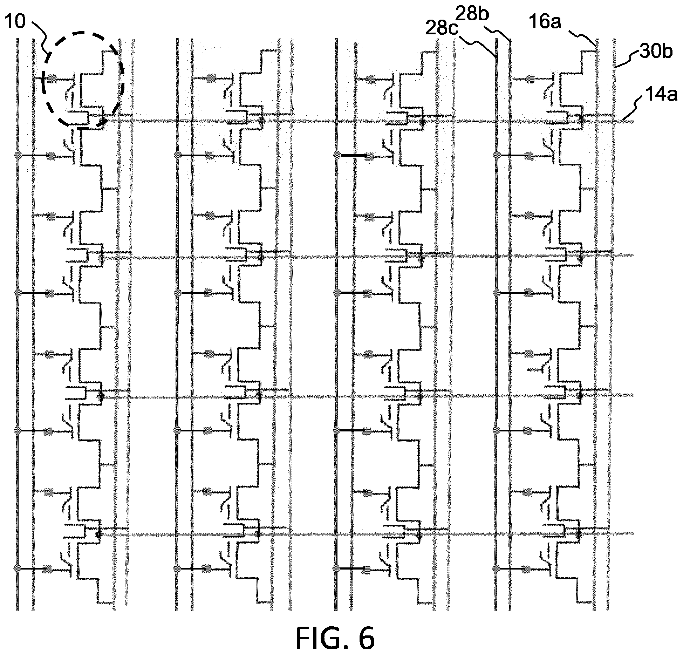

Fig. 6 illustrates yet another alternate embodiment of the 3-gate single bit operation architecture. The main difference between the 3-gate single bit operation architecture of Fig. 6, and the conventional 3-gate architecture discussed above with respect to Fig. 2, is that horizontal word lines 28a (one for each row) have been replaced with vertical word lines 28b and 28c for each column. Specifically, each column of memory cells includes a word line 28b electrically connecting together all the select gates 28 in the odd rows of memory cells for the column of memory cells, and a word line 28c electrically connecting together all the select gates 28 in the even rows of memory cells for the column of memory cells. By reorienting the word lines in this manner, any memory cell in the array can be individually programmed, erased and read without adversely affecting the memory state of adjacent memory cells. The Table 2 operational values similarly apply to this embodiment.

It is to be understood that the present invention is not limited to the embodiment(s) described above and illustrated herein, but encompasses any and all variations falling within the scope of the claims. For example, references to the present invention herein are not intended to limit the scope of any claim or claim term, but instead merely make reference to one or more features that may be covered by one or more claims. Materials, processes and numerical examples described above are exemplary only, and should not be deemed to limit the claims. Lastly, single layers of material could be formed as multiple layers of such or similar materials, and vice versa.

It should be noted that, as used herein, the terms "over" and "on" both inclusively include "directly on" (no intermediate materials, elements or space disposed therebetween) and "indirectly on" (intermediate materials, elements or space disposed therebetween). Likewise, the term "adjacent" includes "directly adjacent" (no intermediate materials, elements or space disposed therebetween) and "indirectly adjacent" (intermediate materials, elements or space disposed there between), "mounted to" includes "directly mounted to" (no intermediate materials, elements or space disposed there between) and "indirectly mounted to" (intermediate materials, elements or spaced disposed there between), and "electrically coupled" includes "directly electrically coupled to" (no intermediate materials or elements there between that electrically connect the elements together) and "indirectly electrically coupled to" (intermediate materials or elements there between that electrically connect the elements together). For example, forming an element "over a substrate" can include forming the element directly on the substrate with no intermediate materials/elements therebetween, as well as forming the element indirectly on the substrate with one or more intermediate materials/elements there between.

## Claims

1. A memory device, comprising:
a substrate of semiconductor material;
a plurality of memory cells (10) formed on the substrate and arranged in an array of rows and columns, wherein the memory cells are arranged in pairs of the memory cells; and
each of the pairs of memory cells shares one of the source regions (14) and one of the source lines (14b);
each of the memory cells (10) includes:
spaced apart source and drain regions (14, 16) in the substrate, with a channel region in the substrate extending there between,
a floating gate (20) disposed over and insulated from a first portion of the channel region which is adjacent the source region,
a select gate (28) disposed over and insulated from a second portion of the channel region which is adjacent the drain region, and
a program-erase gate (30) disposed over and insulated from the source region (14);
each of the columns of memory cells includes a bit line (16a) that electrically connects together all the drain regions (16) for the column of memory cells;
each of the rows of memory cells includes a select gate line (28a) that electrically connects together all the select gates of the memory cells for the row of memory cells; and
each of the rows of memory cells includes a program-erase gate line (30a) that electrically connects together all the program-erase gates of the memory cells for the row of memory cells,
the memory device **characterised in that**:
each of the columns of the memory cells includes a source line (14b) that electrically connects all the source regions (14) for the column of the memory cells.

2. A memory device, comprising:
a substrate of semiconductor material;
a plurality of memory cells (10) formed on the substrate and arranged in an array of rows and columns, wherein the rows of the memory cells are arranged in alternating even and odd numbered rows, the memory cells are arranged in pairs of the memory cells; and each of the pairs of memory cells shares one of the source regions (14) and one of the source lines (14a);
each of the memory cells (10) includes:
spaced apart source and drain regions (14, 16) in the substrate, with a channel region in the substrate extending there between,
a floating gate (20) disposed over and insulated from a first portion of the channel region which is adjacent the source region,
a select gate (28) disposed over and insulated from a second portion of the channel region which is adjacent the drain region, and
a program-erase gate (30) disposed over and insulated from the source region (14);
each of the rows of memory cells includes a source line (14a) that electrically connects together all the source regions for the row of memory cells;
each of the columns of memory cells includes a bit line (16a) that electrically connects together all the drain regions for the column of memory cells; the memory device **characterised in that**:
each of the columns of memory cells includes a first select gate line (28b) that electrically connects together all the select gates of the memory cells for the column of memory cells that are in the odd numbered rows or the even numbered rows of the memory cells;
each of the columns of memory cells includes a program-erase gate line (30b) that electrically connects together all the program-erase gates of the memory cells for the column of memory cells.

3. The memory device of claim 2, wherein the first select gate line for each of the columns of memory cells electrically connects together all the select gates of the memory cells for the column of memory cells that are in the odd numbered rows of the memory cells, and wherein each of the columns of memory cells further comprises a second select gate line that electrically connects together all the select gates of the memory cells for the column of memory cells that are in the even numbered rows of the memory cells.

4. The memory device of claim 1 or claim 2, wherein for each of the memory cells, the select gate has a first portion laterally adjacent to the floating gate and a second portion that extends up and over the floating gate, and the program-erase gate has a first portion laterally adjacent to the floating gate and a second portion that extends up and over the floating gate.

5. A method of erasing a selected memory cell of a memory device, wherein the memory device comprises:
a substrate of semiconductor material;
a plurality of memory cells (10) formed on the substrate and arranged in an array of rows and columns, wherein one of the plurality of memory cells is a selected memory cell, the memory cells are arranged in pairs of the memory cells; and each of the pairs of memory cells shares one of the source regions (14) and one of the source lines (14b);
each of the memory cells (10) includes:
spaced apart source and drain regions (14, 16) in the substrate, with a channel region in the substrate extending there between,
a floating gate (20) disposed over and insulated from a first portion of the channel region which is adjacent the source region,
a select gate (28) disposed over and insulated from a second portion of the channel region which is adjacent the drain region, and
a program-erase gate (30) disposed over and insulated from the source region;
each of the columns of memory cells includes a source line (14b) that electrically connects together all the source regions for the column of memory cells;
each of the columns of memory cells includes a bit line (16b) that electrically connects together all the drain regions for the column of memory cells;
each of the rows of memory cells includes a select gate line (28a) that electrically connects together all the select gates of the memory cells for the row of memory cells;
each of the rows of memory cells includes a program-erase gate line (30a) that electrically connects together all the program-erase gates of the memory cells for the row of memory cells;
the method comprising:
applying a positive voltage to one of the program-erase gate lines (30a) that is electrically connected to the program-erase gate (30) of the selected memory cell, and a ground voltage to all the others of the program-erase gate lines;
applying a ground voltage to one of the source lines that is electrically connected to the source region of the selected memory cell, and a positive voltage to all the others of the source lines, wherein the positive voltage applied to the one of the program-erase gate lines is greater than the positive voltage applied to the others of the source lines.

6. The method of claim 5, further comprising:
applying a ground voltage to one of the bit lines that is electrically connected to the drain region of the selected memory cell, and a ground or positive voltage to all the others of the bit lines.

7. The method of claim 5, wherein the positive voltage applied to the one of the program-erase gate lines is more than double that of the positive voltage applied to the others of the source lines.

8. A method of erasing a selected memory cell of a memory device, wherein the memory device comprises:
a substrate of semiconductor material;
a plurality of memory cells (10) formed on the substrate and arranged in an array of even and odd numbered rows and even and odd numbered columns, wherein one of the plurality of memory cells is a selected memory cell, the memory cells are arranged in pairs of the memory cells; and each of the pairs of memory cells shares one of the source regions (14) and one of the source linesa (14a);
each of the memory cells (10) includes:
spaced apart source and drain regions (14, 16) in the substrate, with a channel region in the substrate extending there between,
a floating gate (20) disposed over and insulated from a first portion of the channel region which is adjacent the source region,
a select gate (28) disposed over and insulated from a second portion of the channel region which is adjacent the drain region, and
a program-erase gate (30) disposed over and insulated from the source region;
each of the rows of memory cells includes a source line (14a) that electrically connects together all the source regions for the row of memory cells;
each of the columns of memory cells includes a bit line (16a) that electrically connects together all the drain regions for the column of memory cells;
each of the columns of memory cells includes a first select gate line (28b) that electrically connects together all the select gates of the memory cells for the column of memory cells that are in the odd numbered rows or the even numbered rows of the memory cells;
each of the columns of memory cells includes a program-erase gate line (30b) that electrically connects together all the program-erase gates of the memory cells for the column of memory cells;
the method comprising:
applying a positive voltage to one of the program-erase gate lines (30b) that is electrically connected to the program-erase gate of the selected memory cell, and a ground voltage to all the others of the program-erase gate lines;
applying a ground voltage to one of the source lines that is electrically connected to the source region of the selected memory cell, and a positive voltage to all the others of the source lines, wherein
the positive voltage applied to the one of the program-erase gate lines is greater than the positive voltage applied to the others of the source lines.

9. The method of claim 8, wherein the first select gate line for each of the columns of memory cells electrically connects together all the select gates of the memory cells for the column of memory cells that are in the odd numbered rows of the memory cells, and wherein each of the columns of memory cells further comprises a second select gate line that electrically connects together all the select gates of the memory cells for the column of memory cells that are in the even numbered rows of the memory cells.

10. The method of claim 8, further comprising:
applying a ground voltage to one of the bit lines that is electrically connected to the drain region of the selected memory cell, and a ground or positive voltage to all the others of the bit lines.

11. The method of claim 8, wherein the positive voltage applied to the one of the program-erase gate lines is more than double that of the positive voltage applied to the others of the source lines.

## Patentansprüche

1. Speichervorrichtung, umfassend:
ein Substrat aus Halbleitermaterial;
eine Vielzahl von Speicherzellen (10), die auf dem Substrat ausgebildet und in einem Array von Zeilen und Spalten angeordnet sind, wobei die Speicherzellen in Paaren von Speicherzellen angeordnet sind; und jedes der Paare von Speicherzellen einen der Source-Bereiche (14) und eine der Source-Leitungen (14b) gemeinsam nutzt;
jede der Speicherzellen (10) schließt ein:
voneinander beabstandete Source- und Drain-Bereiche (14, 16) in dem Substrat, wobei sich ein Kanalbereich in dem Substrat dazwischen erstreckt,
ein Floating-Gate (20), das über einem ersten Abschnitt des Kanalbereichs, der an den Source-Bereich angrenzt, angeordnet und von diesem isoliert ist,
ein Auswahl-Gate (28), das über einem zweiten Abschnitt des Kanalbereichs, der an den Drain-Bereich angrenzt, angeordnet und von diesem isoliert ist, und
ein Programm-Lösch-Gate (30), das über dem Source-Bereich (14) angeordnet und von diesem isoliert ist;
jede der Spalten von Speicherzellen schließt eine Bitleitung (16a) ein, die alle Drain-Bereiche (16) für die Spalte von Speicherzellen elektrisch miteinander verbindet;
jede der Zeilen von Speicherzellen schließt eine Auswahl-Gate-Leitung (28a) ein, die alle Auswahl-Gates der Speicherzellen für die Zeile von Speicherzellen elektrisch miteinander verbindet; und
jede der Zeilen von Speicherzellen schließt eine Programm-Lösch-Gate-Leitung (30a) ein, die alle Programm-Lösch-Gates der Speicherzellen für die Zeile von Speicherzellen elektrisch miteinander verbindet,
wobei die Speichervorrichtung **dadurch gekennzeichnet ist, dass:**
jede der Spalten der Speicherzellen eine Source-Leitung (14b) einschließt, die alle Source-Bereiche (14) für die Spalte der Speicherzellen elektrisch verbindet.

2. Speichervorrichtung, umfassend:
ein Substrat aus Halbleitermaterial;
eine Vielzahl von Speicherzellen (10), die auf dem Substrat ausgebildet und in einem Array von Zeilen und Spalten angeordnet sind, wobei die Zeilen der Speicherzellen in abwechselnd geradzahligen und ungeradzahligen Zeilen angeordnet sind, wobei die Speicherzellen in Paaren von Speicherzellen angeordnet sind; und jedes der Paare von Speicherzellen einen der Source-Bereiche (14) und eine der Source-Leitungen (14a) gemeinsam nutzt;
jede der Speicherzellen (10) schließt ein:
voneinander beabstandete Source- und Drain-Bereiche (14, 16) in dem Substrat, wobei sich ein Kanalbereich in dem Substrat dazwischen erstreckt,
ein Floating-Gate (20), das über einem ersten Abschnitt des Kanalbereichs, der an den Source-Bereich angrenzt, angeordnet und von diesem isoliert ist,
ein Auswahl-Gate (28), das über einem zweiten Abschnitt des Kanalbereichs, der an den Drain-Bereich angrenzt, angeordnet und von diesem isoliert ist, und
ein Programm-Lösch-Gate (30), das über dem Source-Bereich (14) angeordnet und von diesem isoliert ist;
jede der Zeilen von Speicherzellen schließt eine Source-Leitung (14a) ein, die alle Source-Bereiche für die Zeile von Speicherzellen elektrisch miteinander verbindet;
jede der Spalten von Speicherzellen schließt eine Bitleitung (16a) ein, die alle Drain-Bereiche für die Spalte von Speicherzellen elektrisch miteinander verbindet;
wobei die Speichervorrichtung **dadurch gekennzeichnet ist, dass:**
jede der Spalten von Speicherzellen eine erste Auswahl-Gate-Leitung (28b) einschließt, die elektrisch alle Auswahl-Gates der Speicherzellen für die Spalte von Speicherzellen miteinander verbindet, die sich in den ungeradzahligen Zeilen oder in den geradzahligen Zeilen der Speicherzellen befinden;
jede der Spalten von Speicherzellen eine Programm-Lösch-Gate-Leitung (30b) einschließt, die alle Programm-Lösch-Gates der Speicherzellen für die Spalte von Speicherzellen elektrisch miteinander verbindet.

3. Speichervorrichtung nach Anspruch 2, wobei die erste Auswahl-Gate-Leitung für jede der Spalten von Speicherzellen alle Auswahl-Gates der Speicherzellen für die Spalte von Speicherzellen elektrisch miteinander verbindet, die sich in den ungeradzahligen Zeilen der Speicherzellen befinden, und wobei jede der Spalten von Speicherzellen ferner eine zweite Auswahl-Gate-Leitung umfasst, die alle Auswahl-Gates der Speicherzellen für die Spalte von Speicherzellen elektrisch miteinander verbindet, die sich in den geradzahligen Zeilen der Speicherzellen befinden.

4. Speichervorrichtung nach Anspruch 1 oder Anspruch 2, wobei für jede der Speicherzellen das Auswahl-Gate einen ersten Abschnitt aufweist, der seitlich an das Floating-Gate angrenzt, und einen zweiten Abschnitt aufweist, der sich nach oben und über das Floating-Gate erstreckt, und das Programm-Lösch-Gate einen ersten Abschnitt aufweist, der seitlich an das Floating-Gate angrenzt, und einen zweiten Abschnitt aufweist, der sich nach oben und über das Floating-Gate erstreckt.

5. Verfahren zum Löschen einer ausgewählten Speicherzelle einer Speichervorrichtung, wobei die Speichervorrichtung umfasst:
ein Substrat aus Halbleitermaterial;
eine Vielzahl von Speicherzellen (10), die auf dem Substrat ausgebildet und in einem Array von Zeilen und Spalten angeordnet sind, wobei eine der Vielzahl von Speicherzellen eine ausgewählte Speicherzelle ist, wobei die Speicherzellen in Paaren von Speicherzellen angeordnet sind; und jedes der Paare von Speicherzellen einen der Source-Bereiche (14) und eine der Source-Leitungen (14b) gemeinsam nutzt;
jede der Speicherzellen (10) schließt ein:
voneinander beabstandete Source- und Drain-Bereiche (14, 16) in dem Substrat, wobei sich ein Kanalbereich in dem Substrat dazwischen erstreckt,
ein Floating-Gate (20), das über einem ersten Abschnitt des Kanalbereichs, der an den Source-Bereich angrenzt, angeordnet und von diesem isoliert ist,
ein Auswahl-Gate (28), das über einem zweiten Abschnitt des Kanalbereichs, der an den Drain-Bereich angrenzt, angeordnet und von diesem isoliert ist, und
ein Programm-Lösch-Gate (30), das über dem Source-Bereich angeordnet und von diesem isoliert ist;
jede der Spalten von Speicherzellen schließt eine Source-Leitung (14b) ein, die alle Source-Bereiche für die Spalte von Speicherzellen elektrisch miteinander verbindet;
jede der Spalten von Speicherzellen schließt eine Bitleitung (16b) ein, die alle Drain-Bereiche für die Spalte von Speicherzellen elektrisch miteinander verbindet;
jede der Zeilen von Speicherzellen schließt eine Auswahl-Gate-Leitung (28a) ein, die alle Auswahl-Gates der Speicherzellen für die Zeile von Speicherzellen elektrisch miteinander verbindet;
jede der Zeilen von Speicherzellen schließt eine Programm-Lösch-Gate-Leitung (30a) ein; die alle Programm-Lösch-Gates der Speicherzellen für die Zeile von Speicherzellen elektrisch miteinander verbindet;
das Verfahren umfassend:
Anlegen einer positiven Spannung an eine der Programm-Lösch-Gate-Leitungen (30a), die elektrisch mit dem Programm-Lösch-Gate (30) der ausgewählten Speicherzelle verbunden ist, und einer Masse-Spannung an alle anderen der Programm-Lösch-Gate-Leitungen;
Anlegen einer Masse-Spannung an eine der Source-Leitungen, die elektrisch mit dem Source-Bereich der ausgewählten Speicherzelle verbunden ist, und einer positiven Spannung an alle anderen der Source-Leitungen, wobei die an die eine der Programm-Lösch-Gate-Leitungen angelegte positive Spannung größer als die an die anderen der Source-Leitungen angelegte positive Spannung ist.

6. Verfahren nach Anspruch 5, ferner umfassend:
Anlegen einer Masse-Spannung an eine der Bitleitungen, die elektrisch mit dem Drain-Bereich der ausgewählten Speicherzelle verbunden ist, und einer Masse- oder positiven Spannung an alle anderen der Bitleitungen.

7. Verfahren nach Anspruch 5, wobei die an die eine der Programm-Lösch-Gate-Leitungen angelegte positive Spannung mehr als doppelt so groß wie die an die anderen der Source-Leitungen angelegte positive Spannung ist.

8. Verfahren zum Löschen einer ausgewählten Speicherzelle einer Speichervorrichtung, wobei die Speichervorrichtung umfasst:
ein Substrat aus Halbleitermaterial;
eine Vielzahl von Speicherzellen (10), die auf dem Substrat ausgebildet und in einem Array aus geradzahligen und ungeradzahligen Zeilen und geradzahligen und ungeradzahligen Spalten angeordnet sind, wobei eine der Vielzahl von Speicherzellen eine ausgewählte Speicherzelle ist, wobei die Speicherzellen in Paaren der Speicherzellen angeordnet sind; und jedes der Paare von Speicherzellen einen der Source-Bereiche (14) und eine der Source-Leitungen (14a) gemeinsam nutzt;
jede der Speicherzellen (10) schließt ein:
voneinander beabstandete Source- und Drain-Bereiche (14, 16) in dem Substrat, wobei sich ein Kanalbereich in dem Substrat dazwischen erstreckt,
ein Floating-Gate (20), das über einem ersten Abschnitt des Kanalbereichs, der an den Source-Bereich angrenzt, angeordnet und von diesem isoliert ist,
ein Auswahl-Gate (28), das über einem zweiten Abschnitt des Kanalbereichs, der an den Drain-Bereich angrenzt, angeordnet und von diesem isoliert ist, und
ein Programm-Lösch-Gate (30), das über dem Source-Bereich angeordnet und von diesem isoliert ist;
jede der Zeilen von Speicherzellen schließt eine Source-Leitung (14a) ein, die alle Source-Bereiche für die Zeile von Speicherzellen elektrisch miteinander verbindet;
jede der Spalten von Speicherzellen schließt eine Bitleitung (16a) ein, die alle Drain-Bereiche für die Spalte von Speicherzellen elektrisch miteinander verbindet;
jede der Spalten von Speicherzellen schließt eine erste Auswahl-Gate-Leitung (28b) ein, die elektrisch alle Auswahl-Gates der Speicherzellen für die Spalte von Speicherzellen miteinander verbindet, die sich in den ungeradzahligen Zeilen oder in den geradzahligen Zeilen der Speicherzellen befinden;
jede der Spalten von Speicherzellen schließt eine Programm-Lösch-Gate-Leitung (30b) ein, die alle Programm-Lösch-Gates der Speicherzellen für die Spalte von Speicherzellen elektrisch miteinander verbindet;
das Verfahren umfassend:
Anlegen einer positiven Spannung an eine der Programm-Lösch-Gate-Leitungen (30b), die elektrisch mit dem Programm-Lösch-Gate der ausgewählten Speicherzelle verbunden ist, und einer Masse-Spannung an alle anderen der Programm-Lösch-Gate-Leitungen;
Anlegen einer Masse-Spannung an eine der Source-Leitungen, die elektrisch mit dem Source-Bereich der ausgewählten Speicherzelle verbunden ist, und einer positiven Spannung an alle anderen der Source-Leitungen, wobei
die an die eine der Programm-Lösch-Gate-Leitungen angelegte positive Spannung größer als die an die anderen der Source-Leitungen angelegte positive Spannung ist.

9. Verfahren nach Anspruch 8, wobei die erste Auswahl-Gate-Leitung für jede der Spalten von Speicherzellen alle Auswahl-Gates der Speicherzellen für die Spalte von Speicherzellen elektrisch miteinander verbindet, die sich in den ungeradzahligen Zeilen der Speicherzellen befinden, und wobei jede der Spalten von Speicherzellen ferner eine zweite Auswahl-Gate-Leitung umfasst, die alle Auswahl-Gates der Speicherzellen für die Spalte von Speicherzellen elektrisch miteinander verbindet, die sich in den geradzahligen Zeilen der Speicherzellen befinden.

10. Verfahren nach Anspruch 8, ferner umfassend:
Anlegen einer Masse-Spannung an eine der Bitleitungen, die elektrisch mit dem Drain-Bereich der ausgewählten Speicherzelle verbunden ist, und einer Masse- oder positiven Spannung an alle anderen der Bitleitungen.

11. Verfahren nach Anspruch 8, wobei die an die eine der Programm-Lösch-Gate-Leitungen angelegte positive Spannung mehr als doppelt so groß wie die an die anderen der Source-Leitungen angelegte positive Spannung ist.

## Revendications

1. Dispositif de mémoire, comprenant :
un substrat de matériau semi-conducteur ;
une pluralité de cellules de mémoire (10) formées sur le substrat et agencées dans une matrice de rangées et de colonnes, dans lequel les cellules de mémoire sont agencées en paires des cellules de mémoire ; et chacune des paires de cellules de mémoire partage une des régions de source (14) et une des lignes de source (14b) ;
chacune des cellules de mémoire (10) inclut :
des régions de source et de drain espacées (14, 16) dans le substrat, avec une région de canal dans le substrat s'étendant entre elles,
une grille flottante (20) disposée par-dessus et isolée d'une première partie de la région de canal qui est adjacente à la région de source,
une grille de sélection (28) disposée par-dessus et isolée d'une deuxième partie de la région de canal qui est adjacente à la région de drain, et
une grille de programmation-effacement (30) disposée par-dessus et isolée de la région de source (14) ;
chacune des colonnes de cellules de mémoire inclut une ligne de bit (16a) qui connecte électriquement ensemble toutes les régions de drain (16) pour la colonne de cellules de mémoire ;
chacune des rangées de cellules de mémoire inclut une ligne de grille de sélection (28a) qui connecte électriquement ensemble toutes les grilles de sélection des cellules de mémoire pour la rangée de cellules de mémoire ; et
chacune des rangées de cellules de mémoire inclut une ligne de grille de programmation-effacement (30a) qui connecte électriquement ensemble toutes les grille de programmation-effacement des cellules de mémoire pour la rangée de cellules de mémoire,
le dispositif de mémoire **caractérisé en ce que** :
chacune des colonnes des cellules de mémoire inclut une ligne de source (14b) qui connecte électriquement toutes les régions de source (14) pour la colonne des cellules de mémoire.

2. Dispositif de mémoire, comprenant :
un substrat de matériau semi-conducteur ;
une pluralité de cellules de mémoire (10) formées sur le substrat et agencées dans une matrice de rangées et colonnes, dans lequel les rangées des cellules de mémoire sont agencées en rangées alternées à numérotation paire et impaire, les cellules de mémoire sont agencées en paires des cellules de mémoire ; et chacune des paires de cellules de mémoire partage une des régions de source (14) et une des lignes de source (14a) ;
chacune des cellules de mémoire (10) inclut :
des régions de source et de drain espacées (14, 16) dans le substrat, avec une région de canal dans le substrat s'étendant entre elles,
une grille flottante (20) disposée par-dessus et isolée d'une première partie de la région de canal qui est adjacente à la région de source,
une grille de sélection (28) disposée par-dessus et isolée d'une deuxième partie de la région de canal qui est adjacente à la région de drain, et
une grille de programmation-effacement (30) disposée par-dessus et isolée de la région de source (14) ;
chacune des rangées de cellules de mémoire inclut une ligne de source (14a) qui connecte électriquement ensemble toutes les régions de source pour la rangée de cellules de mémoire ;
chacune des colonnes de cellules de mémoire inclut une ligne de bit (16a) qui connecte électriquement ensemble toutes les régions de drain pour la colonne de cellules de mémoire ;
le dispositif de mémoire **caractérisé en ce que** :
chacune des colonnes de cellules de mémoire inclut une première ligne de grille de sélection (28b) qui connecte électriquement ensemble toutes les grilles de sélection des cellules de mémoire pour la colonne de cellules de mémoire qui sont dans les rangées à numérotation impaire ou les rangées à numérotation paire des cellules de mémoire ;
chacune des colonnes de cellules de mémoire inclut une ligne de grille de programmation-effacement (30b) qui connecte électriquement ensemble toutes les grilles de programmation-effacement des cellules de mémoire pour la colonne de cellules de mémoire.

3. Dispositif de mémoire selon la revendication 2, dans lequel la première ligne de grille de sélection pour chacune des colonnes de cellules de mémoire connecte électriquement ensemble toutes les grilles de sélection des cellules de mémoire pour la colonne de cellules de mémoire qui sont dans les rangées à numérotation impaire des cellules de mémoire, et dans lequel chacune des colonnes de cellules de mémoire comprend en outre une deuxième ligne de grille de sélection qui connecte électriquement ensemble toutes les grilles de sélection des cellules de mémoire pour la colonne de cellules de mémoire qui sont dans les rangées à numérotation paire des cellules de mémoire.

4. Dispositif de mémoire selon la revendication 1 ou la revendication 2, dans lequel pour chacune des cellules de mémoire, la grille de sélection a une première partie latéralement adjacente à la grille flottante et une deuxième partie qui s'étend jusqu'à et par-dessus la grille flottante, et la grille de programmation-effacement a une première partie latéralement adjacente à la grille flottante et une deuxième partie qui s'étend jusqu'à et par-dessus la grille flottante.

5. Procédé d'effacement d'une cellule de mémoire sélectionnée d'un dispositif de mémoire, dans lequel le dispositif de mémoire comprend :
un substrat de matériau semi-conducteur ;
une pluralité de cellules de mémoire (10) formées sur le substrat et agencées dans une matrice de rangées et colonnes, dans lequel une parmi la pluralité de cellules de mémoire est une cellule de mémoire sélectionnée, les cellules de mémoire sont agencées en paires des cellules de mémoire ; et chacune des paires de cellules de mémoire partage une des régions de source (14) et une des lignes de source (14b) ;
chacune des cellules de mémoire (10) inclut :
des régions de source et de drain espacées (14, 16) dans le substrat, avec une région de canal dans le substrat s'étendant entre elles,
une grille flottante (20) disposée par-dessus et isolée d'une première partie de la région de canal qui est adjacente à la région de source,
une grille de sélection (28) disposée par-dessus et isolée d'une deuxième partie de la région de canal qui est adjacente à la région de drain, et
une grille de programmation-effacement (30) disposée par-dessus et isolée de la région de source ;
chacune des colonnes de cellules de mémoire inclut une ligne de source (14b) qui connecte électriquement ensemble toutes les régions de source pour la colonne de cellules de mémoire ;
chacune des colonnes de cellules de mémoire inclut une ligne de bit (16b) qui connecte électriquement ensemble toutes les régions de drain pour la colonne de cellules de mémoire ;
chacune des rangées de cellules de mémoire inclut une ligne de grille de sélection (28a) qui connecte électriquement ensemble toutes les grilles de sélection des cellules de mémoire pour la rangée de cellules de mémoire ;
chacune des rangées de cellules de mémoire inclut une ligne de grille de programmation-effacement (30a) qui connecte électriquement ensemble toutes les grille de programmation-effacement des cellules de mémoire pour la rangée de cellules de mémoire ;
le procédé comprenant :
l'application d'une tension positive à une des lignes de grille de programmation-effacement (30a) qui est connectée électriquement à la grille de programmation-effacement (30) de la cellule de mémoire sélectionnée, et une tension de masse à toutes les autres des lignes de grille de programmation-effacement ;
l'application d'une tension de masse à une des lignes de source qui est connectée électriquement à la région de source de la cellule de mémoire sélectionnée, et une tension positive à toutes les autres des lignes de source, dans lequel la tension positive appliquée à cette ligne des lignes de grille de programmation-effacement est supérieure à la tension positive appliquée aux autres des lignes de source.

6. Procédé selon la revendication 5, comprenant en outre :
l'application d'une tension de masse à une des lignes de bit qui est connectée électriquement à la région de drain de la cellule de mémoire sélectionnée, et d'une tension positive de masse à toutes les autres des lignes de bit.

7. Procédé selon la revendication 5, dans lequel la tension positive appliquée à cette ligne des lignes de grille de programmation-effacement vaut plus du double de la tension positive appliquée aux autres des lignes de source.

8. Procédé d'effacement d'une cellule de mémoire sélectionnée d'un dispositif de mémoire, dans lequel le dispositif de mémoire comprend :
un substrat de matériau semi-conducteur ;
une pluralité de cellules de mémoire (10) formées sur le substrat et agencées dans une matrice de rangées à numérotation paire et impaire et de colonnes à numérotation paire et impaire, dans lequel une parmi la pluralité de cellules de mémoire est une cellule de mémoire sélectionnée, les cellules de mémoire sont agencées en paires des cellules de mémoire ; et chacune des paires de cellules de mémoire partage une des régions de source (14) et une des lignes de source (14a) ;
chacune des cellules de mémoire (10) inclut :
des régions de source et de drain espacées (14, 16) dans le substrat, avec une région de canal dans le substrat s'étendant entre elles,
une grille flottante (20) disposée par-dessus et isolée d'une première partie de la région de canal qui est adjacente à la région de source,
une grille de sélection (28) disposée par-dessus et isolée d'une deuxième partie de la région de canal qui est adjacente à la région de drain, et
une grille de programmation-effacement (30) disposée par-dessus et isolée de la région de source ;
chacune des rangées de cellules de mémoire inclut une ligne de source (14a) qui connecte électriquement ensemble toutes les régions de source pour la rangée de cellules de mémoire ;
chacune des colonnes de cellules de mémoire inclut une ligne de bit (16a) qui connecte électriquement ensemble toutes les régions de drain pour la colonne de cellules de mémoire ;
chacune des colonnes de cellules de mémoire inclut une première ligne de grille de sélection (28b) qui connecte électriquement ensemble toutes les grilles de sélection des cellules de mémoire pour la colonne de cellules de mémoire qui sont dans les rangées à numérotation impaire ou les rangées à numérotation paire des cellules de mémoire ;
chacune des colonnes de cellules de mémoire inclut une ligne de grille de programmation-effacement (30b) qui connecte électriquement ensemble toutes les grilles de programmation-effacement des cellules de mémoire pour la colonne de cellules de mémoire ;
le procédé comprenant :
l'application d'une tension positive à une des lignes de grille de programmation-effacement (30b) qui est connectée électriquement à la grille de programmation-effacement de la cellule de mémoire sélectionnée, et une tension de masse à toutes les autres des lignes de grille de programmation-effacement ;
l'application d'une tension de masse à une des lignes de source qui est connectée électriquement à la région de source de la cellule de mémoire sélectionnée, et d'une tension positive à toutes les autres des lignes de source, dans lequel
la tension positive appliquée à cette ligne des lignes de grille de programmation-effacement est supérieure à la tension positive appliquée aux autres des lignes de source.

9. Procédé selon la revendication 8, dans lequel la première ligne de grille de sélection pour chacune des colonnes de cellules de mémoire connecte électriquement ensemble toutes les grilles de sélection des cellules de mémoire pour la colonne de cellules de mémoire qui sont dans les rangées à numérotation impaire des cellules de mémoire, et dans lequel chacune des colonnes de cellules de mémoire comprend en outre une deuxième ligne de grille de sélection qui connecte électriquement ensemble toutes les grilles de sélection des cellules de mémoire pour la colonne de cellules de mémoire qui sont dans les rangées à numérotation paire des cellules de mémoire.

10. Procédé selon la revendication 8, comprenant en outre :
l'application d'une tension de masse à une des lignes de bit qui est connectée électriquement à la région de drain de la cellule de mémoire sélectionnée, et d'une tension positive de masse à toutes les autres des lignes de bit.

11. Procédé selon la revendication 8, dans lequel la tension positive appliquée à cette ligne des lignes de grille de programmation-effacement vaut plus du double de la tension positive appliquée aux autres des lignes de source.
